# EUROPÄISCHE PATENTANMELDUNG

(11) **EP 4 032 997 A1**
(43) Veröffentlichungstag der Anmeldung: **27.07.2022**
(21) Anmeldenummer: 21153489.6
(22) Anmeldetag: 26.01.2021
(51) Int. Cl.: C22C 19/05, C30B 11/14, C30B 29/52

(54) **NICKELBASISLEGIERUNG UND BAUTEIL AUS DIESER**

(71) Anmelder: MTU Aero Engines AG, 80995 München (DE)
(72) Erfinder: Schwalbe, Caspar, 80995 München (DE); Futoma, Magdalena, 80995 München (DE); Göhler, Thomas, 80995 München (DE); Sowa, Roman, 80995 München (DE)

(57) **Zusammenfassung**

Nickelbasislegierung für Hochtemperaturanwendungen, insbesondere zur Verwendung in Strömungsmaschinen, mit einer chemischen Zusammensetzung umfasst: 5,9 bis 6,3 Gew.% Al, 6 bis 11 Gew.% Co, 5,5 bis 7,5 Gew.% Cr, 0 bis 0,5 Gew.% Hf, 0 bis 1 Gew.% Mo, 1 bis 2 Gew.% Re, 5 bis 7,8 Gew.% Ta,5 bis 8,5 Gew.% W, 0,01 bis 1 Gew.% C, 0 bis 0,5 Gew.% Ti, 0 bis 0,01 Gew.% B,0 bis 0,08 Gew.% Y,0 bis 0,5 Gew.% Zr,0 bis 0,8 Gew.% Nb und Rest Nickel sowie unvermeidbare Verunreinigungen.

## Beschreibung

### HINTERGRUND DER ERFINDUNG

### GEBIET DER ERFINDUNG

Die Erfindung betrifft eine Nickelbasislegierung, insbesondere eine Nickelbasis-Superlegierung für Hochtemperaturanwendungen, vorzugsweise zur Verwendung in Strömungsmaschinen, wie Flugtriebwerken, sowie ein entsprechendes Bauteil einer Strömungsmaschine, insbesondere eines Flugtriebwerks aus einer derartigen Nickelbasislegierung.

Unter Nickelbasislegierung ist ein Werkstoff zu verstehen, der im Hauptbestandteil Nickel aufweist. Eine besondere Ausgestaltung von Nickelbasislegierungen stellen Nickelbasis - Superlegierungen dar, unter denen Legierungen zu verstehen sind, die durch ihre besondere Zusammensetzung und Gefügeausbildung bei hohen Temperaturen bis nahe zu ihrem Schmelzpunkt einsetzbar ist. Der Begriff der Nickelbasislegierung, wie er nachfolgend verwendet wird, umfasst somit auch den Begriff der Nickelbasis-Superlegierung.

### STAND DER TECHNIK

Nickelbasis - Superlegierungen werden bei Hochtemperaturanwendungen, z. B. beim Bau von stationären Gasturbinen oder Flugtriebwerken, aufgrund ihrer Hochtemperaturfestigkeit eingesetzt. Unter Hochtemperaturanwendung wird hierbei eine Anwendung verstanden, bei der die Einsatztemperatur eines aus der Legierung hergestellten Bauteils in einem Temperaturbereich oberhalb der halben Schmelztemperatur der Legierung liegt.

Die Nickelbasis - Superlegierungen verdanken ihre guten Hochtemperatureigenschaften und insbesondere ihre hervorragende Hochtemperaturfestigkeit einer speziellen Gefügeausbildung, die durch eine γ - Matrix und darin eingelagerte γ' - Ausscheidungen gekennzeichnet ist.

Aus dem Stand der Technik sind Nickelbasis - Superlegierungen mit unterschiedlichen Zusammensetzungen bekannt, wie beispielsweise aus dem Dokument EP3133178A1.

Für bestehende und zukünftige Anwendungen sind Legierungen, die hinsichtlich ihrer Eigenschaften, Verfügbarkeit und/oder Nachhaltigkeit Verbesserungen aufweisen, wünschenswert.

Insbesondere bei Flugtriebwerken gibt es aufgrund des bestehendes Wunsches zu höheren Drehzahlen und Temperaturen im Turbinenbereich, insbesondere im Bereich von ungekühlten Niederdruckturbinenschaufeln, insbesondere bei Temperaturen bis zu 850°C, einen Bedarf an geeigneten, herstellbaren und verfügbaren hochtemperaturstabilen Legierungen.

### OFFENBARUNG DER ERFINDUNG

### AUFGABE DER ERFINDUNG

Es ist Aufgabe der vorliegenden Erfindung, eine Nickelbasislegierung und ein Bauteil bereitzustellen, die besonders Vorteilhaft in Bezug auf ihre Eigenschaften, Verfügbarkeit und Nachhaltigkeit sind.

### TECHNISCHE LÖSUNG

Diese Aufgabe wird gelöst durch eine Nickelbasislegierung mit den Merkmalen des Anspruchs 1, ein Bauteil gemäß Anspruch 7 sowie ein Verfahren nach Anspruch 11. Vorteilhafte Ausgestaltungen sind Gegenstand der abhängigen Ansprüche.

Eine Nickelbasislegierung hat gemäß der vorliegenden Erfindung eine chemische Zusammensetzung mit 5,9 bis 6,3 Gew.% Al, 6 bis 11 Gew.% Co, 5,5 bis 7,5 Gew.% Cr, 0 bis 0,5 Gew.% Hf, 0 bis 1 Gew.% Mo, 1 bis 2 Gew.% Re, 5 bis 7,8 Gew.% Ta, 5 bis 8,5 Gew.% W, 0,01 bis 1 Gew.% C, 0 bis 0,5 Gew.% Ti, 0 bis 0,01 Gew.% B, 0 bis 0,08 Gew.% Y, 0 bis 0,5 Gew.% Zr, 0 bis 0,8 Gew.% Nb und Rest Nickel sowie unvermeidbare Verunreinigungen.

Die Legierung kommt mit einem besonders geringem Rheniumgehalt aus. Rhenium ist selten, in vergleichsweise geringem Umfang verfügbar und stellt Herausforderungen an eine nachhaltige Primärgewinnung. Ein geringer Re-Gehalt kann über eine Sekundärbeschaffung gedeckt werden und bringt damit Vorteile in der Nachhaltigkeit mit sich.

Zwar hat Rhenium hat einen besonders vorteilhaften Effekt auf die Hochtemperaturstabilität, wie Kriechfestigkeit, LCF und HCF. Erfindungsgemäß kann ein geringer Rheniumgehalt, der 2 Gew.% nicht übersteigt, jedoch durch die oben angegebene Ausbalancierung der weiteren Elemente Mo, Ta, Ti und optional Nb vorteilhaft ausgeglichen werden.

Die Legierungszusammensetzung ermöglicht einen ausreichend hohen Anteil der γ' - Ausscheidungen, insbesondere von über 60 vol.% bei 800°C. Die γ' - Ausscheidungen sind insbesondere für die Hochtemperaturstabilität besonders wichtig.

Gleichzeitig ermöglicht die Legierungszusammensetzung einen vorteilhaft geringen Sprödphasenanteil, besonders eine geringe Anfälligkeit gegenüber einer Ausbildung von unerwünschten Inhomogenitäten, insbesondere unerwünschten Strukturen und Defekten in der Kristallstruktur, im Oberflächenbereich des Gussteils, wie sog. "Freckles", eine hohe Festigkeit sowie eine hohe Korrosions- und Oxidationsbeständigkeit auf.

Weiterhin kann die Legierungszusammensetzung eine hinreichende Gießbarkeit bzw. Herstellbarkeit in der erforderlichen Homogenität in der Mikrostruktur des Gefüges zuverlässig sicherstellen. Insbesondere ermöglicht die Legierungszusammensetzung, insbesondere aufgrund der jeweiligen Co- und W-Bereiche, einem besonders großes Prozessfenster von 35°C oder mehr, insbesondere von 40°C oder mehr für eine Wärmebehandlung , insbesondere einem Lösungsglühen, bei der Legierungsherstellung.

Gemäß einer Ausführung hat die Nickelbasislegierung eine chemische Zusammensetzung mit 5,9 bis 6,3 Gew.% Al, 8 bis 11 Gew.% Co, 5,5 bis 7,5 Gew.% Cr, 0 bis 0,5 Gew.% Hf, 0 bis 1 Gew.% Mo, 1 bis 2 Gew.% Re, 5 bis 7,8 Gew.% Ta, 5 bis 8,5 Gew.% W, 0,01 bis 1 Gew.% C, 0 bis 0,5 Gew.% Ti, 0 bis 0,01 Gew.% B, 0 bis 0,08 Gew.% Y, 0 bis 0,5 Gew.% Zr, 0 bis 0,8 Gew.% Nb und Rest Nickel sowie unvermeidbare Verunreinigungen. In vorteilhaften Weiterbildungen dieser Legierung beträgt der Co-Gehalt 8,1 bis 11 Gew.%, 8,2 bis 11 Gew.%, 8,3 bis 11 Gew.%, 8,4 bis 11 Gew.% bzw. 8,5 bis 11 Gew.%. Der geringe Rheniumgehalt kann bei diesen Legierungen besonders vorteilhaft ausgeglichen werden.

Gemäß einer Ausführung hat die Nickelbasislegierung eine chemische Zusammensetzung mit 5,9 bis 6,3 Gew.% Al, 6 bis 10 Gew.% Co, 5,5 bis 7,5 Gew.% Cr, 0 bis 0,5 Gew.% Hf,, 0 bis 1 Gew.% Mo, 1 bis 2 Gew.% Re, 5 bis 7,5 Gew.% Ta, 5,5 bis 8,5 Gew.% W, 0,01 bis 1 Gew.% C, 0 bis 0,5 Gew.% Ti, 0 bis 0,01 Gew.% B, 0 bis 0,08 Gew.% Y, 0 bis 0,5 Gew.% Zr, 0 bis 0,8 Gew. % Nb, und Rest Nickel sowie unvermeidbare Verunreinigungen. In vorteilhaften Weiterbildungen dieser Legierung beträgt der W-Gehalt 7 bis 8 Gew.% W, 7,1 bis 8 Gew.% W, 7,2 bis 8 Gew.% W, 7,3 bis 8 Gew.% W, 7,4 bis 8 Gew.% W bzw, 7,5 bis 8 Gew.% W.

Gemäß einer vorteilhaften Weiterbildung hat die Nickelbasislegierung eine chemische Zusammensetzung mit 5,9 bis 6,3 Gew.% Al, 7,5 bis 8,5 Gew.% Co 5,5 bis 7,5 Gew.% Cr, 0,1 bis 0,45 Gew.% Hf, 0,4 bis 0,9 Gew.% Mo, 1,4 bis 1,7 Gew.% Re, 6 bis 7 Gew.% Ta, 7 bis 8 Gew.% W, 0,02 bis 0,07 Gew.% C, 0 bis 0,3 Gew.% Ti, 0 bis 0,008 Gew.% B, 0 bis 0,04 Gew.% Y, 0 bis 0,016 Gew.% Zr, 0,05 bis 0,1 Gew.% Nb und Rest Nickel sowie unvermeidbare Verunreinigungen. In vorteilhaften Weiterbildungen dieser Legierung beträgt der W-Gehalt 7,1 bis 8 Gew.%, 7,2 bis 8 Gew.%, 7,3 bis 8 Gew.%, 7,4 bis 8 Gew.% bzw, 7,5 bis 8 Gew.%.

Gemäß einer weiteren Ausführung hat die Nickelbasislegierung eine chemische Zusammensetzung mit 5,9 bis 6,3 Gew.% Al, 8 bis 11 Gew.% Co, 0 bis 0,5 Gew.% Hf, 0 bis 1 Gew.% Mo, 1 bis 2 Gew.% Re, 5,5 bis 7,8 Gew.% Ta, 5 bis 8,5 Gew.% W, 0,01 bis 1 Gew.% C, 0 bis 0,5 Gew.% Ti, 0 bis 0,01 Gew.% B, 0 bis 0,08 Gew.% Y, 0 bis 0,5 Gew.% Zr, 0 bis 0,8 Gew.% Nb, und Rest Nickel sowie unvermeidbare Verunreinigungen. In vorteilhaften Weiterbildungen dieser Legierung beträgt der Co-Gehalt 8,1 bis 11 Gew.%, 8,2 bis 11 Gew.%, 8,3 bis 11 Gew.%, 8,4 bis 11 Gew.% bzw. 8,5 bis 11 Gew.%.

Gemäß einer anderen Weiterbildung hat die Nickelbasislegierung eine chemische Zusammensetzung mit 5,9 bis 6,3 Gew.% Al, 8,5 bis 9,5 Gew.% Co, 5,5 bis 7,5 Gew.% Cr, 0,1 bis 0,45 Gew.% Hf,, 0,4 bis 0,9 Gew.% Mo, 1,4 bis 1,7 Gew.% Re, 6,5 bis 7,5 Gew.% Ta, 6,5 bis 7,5 Gew.% W, 0,02 bis 0,07 Gew.% C, 0 bis 0,3 Gew.% Ti, 0 bis 0,008 Gew.% B, 0 bis 0,04 Gew.% Y, 0 bis 0,016 Gew.% Zr, 0,05 bis 0,1 Gew.% Nb und Rest Nickel sowie unvermeidbare Verunreinigungen.

Gemäß einer Ausführung ist die Nickelbasislegierung eine einkristalline Superlegierung, insbesondere mit einer kubisch flächenzentrierten Kristallstruktur.

Die Legierung umfasst vorzugsweise eine γ - Matrix und γ' - Ausscheidungen, wobei der Anteil an γ' - Ausscheidungen in der Legierung im Temperaturbereich bis 850°C insbesondere über 60 Vol.% beträgt. Dadurch kann eine besonders hohe Temperaturstabilität im Bereich bis 850°C erreicht werden.

Die vorliegende Erfindung umfasst zudem auch ein Bauteil einer Strömungsmaschine, insbesondere eines Flugtriebwerks, welches eine Nickelbasislegierung nach einer zuvor genannten Ausführung umfasst oder daraus besteht.

Das Bauteil kann eine Leit- oder Laufschaufel sein, insbesondere für eine Turbinenstufe, insbesondere Niederdruckturbinenstufe, eines Flugtriebwerks. Daneben umfasst die Erfindung auch die Anwendung für Bauteile, insbesondere Leit- oder Laufschaufeln, im Bereich der Hochdruckturbine.

Im Bauteil kann die Nickelbasislegierung einkristallin oder gerichtet erstarrt ausgebildet sein, insbesondere derart, dass die [001]-Kristallrichtung in der hergestellten Leit- oder Laufschaufel um höchstens 15° von der sich in Radialrichtung erstreckenden Schaufelachse abweicht.

Die Turbinenstufe kann mittels eines Getriebes mit einem Fan der des Flugtriebwerks gekoppelt sein. Die Turbine kann dabei im Betrieb schneller drehen als der Fan. Daneben umfasst die Erfindung auch die Anwendung für Flugtriebwerke ohne derartige Getriebe, bei denen also insbesondere eine der Turbinenstufen, welche den Fan antreibt, genauso schnell dreht wie der Fan.Die vorliegende Erfindung umfasst weiterhin ein Verfahren zur Herstellung eines Bauteils nach einer vorgenannten Ausführung, welches den folgenden Schritt umfasst: Gießen einer Schmelze mit einer chemischen Zusammensetzung einer vorgenannten Legierung in eine Gussform für eine Leit- oder Laufschaufel mit einer jeweiligen Schaufelachse in Radialrichtung, wobei die Gussform einen Impfkristall oder sog. "Starter" umfasst, der eine [001]-Kristallrichtung für ein einkristallines Kristallwachstum festlegt und derart in der Gussform orientiert angeordnet ist, dass die [001]-Kristallrichtung im hergestellten Bauteil um höchstens 15° von der Radialrichtung abweicht.

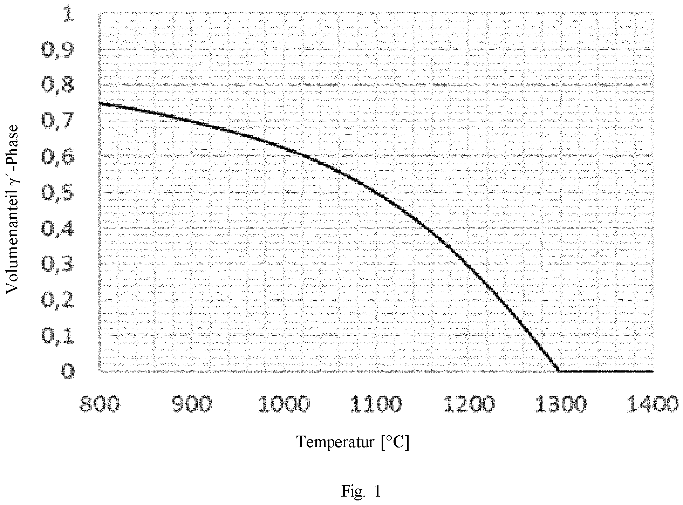

Fig. 1 zeigt für eine erfindungsgemäße Legierung mit einer beispielhaften Zusammensetzung mit 6,1 Gew.% Al, 8 Gew.% Co, 6,5 Gew.% Cr, 0,3 Gew.% Hf, 0,625 Gew.% Mo, 1,5Gew.% Re, 6,5 Gew.% Ta, 7,5 Gew.% W, 0,045 Gew.% C, 0,2 Gew.% Ti, 0,005 Gew.% B, 0,05 Gew.% Nb und Rest Nickelgemäß einer Simulation den Volumenanteil der γ' - Ausscheidungen. Es ist zu erkennen, dass der Anteil der γ' - Ausscheidungen bis zu hohen Temperaturen, insbesondere bis zu 850°C, vorteilhaft hoch, insbesondere über 60 vol.% gehalten werden kann. Die Abhängigkeit vom Re-Gehalt im Bereich von 1 bis 2 Gew.% Re, insbesondere im Bereich von 1,4 bis 1,7 Gew.% Re, ist dabei vorteilhaft gering.

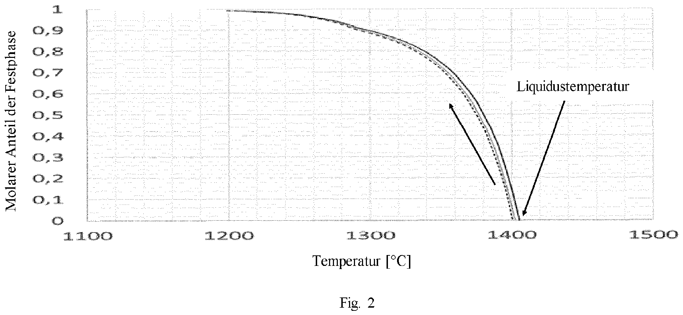

Fig. 2 zeigt auf Basis von einer Simulation für verschiedene beispielhafte, erfindungsgemäße Legierungszusammensetzungen, darunter auch für diejenige aus Fig. 1,den molaren Anteil der festen Phase in Abhängigkeit der Temperatur bei einer Temperaturabnahme, d.h. während des Erstarrungsprozesses. Wie in Fig. 2 ersichtlich, nimmt der molare Anteil der festen Phase gleich zu Beginn des Erstarrungsprozesses bei den gezeigten erfindungsgemäßen Legierungen bei geringer Temperaturabnahme stark zu, insbesondere bei eine Temperaturabnahme von 30°C ab der Liquidustemperatur (entspricht dem Nulldurchgang in der Darstellung der Fig. 2) von Null auf einen molaren Anteil zwischen 0,4 und 0,75, insbesondere 0,5 und 0,7.

Aufgrund dieser vergleichsweise schnellen Erstarrung wird vorteilhafterweise nur ein vergleichsweise geringer Sprödphasenanteil, insbesondere in einigen Ausführungsformen weniger als 5 Gew.%, in einigen Ausführungsformen weniger als 2 Gew.% und in einigen Ausführungsformen sogar weniger als weniger als 1,5Gew.%, und kein oder nur ein geringer µ-Phasenanteil, insbesondere in einigen Ausführungsformen weniger als 2 Gew.%, in einigen Ausführungsformen weniger als 1 Gew.% und in einigen Ausführungsformen sogar weniger als weniger als 0,5 Gew.%, ausbildet. Dadurch können die negativen Auswirkungen eines µ-Phasenanteils auf die mechanischen Eigenschaften, insbesondere eine negative Beeinflussung der Ermüdungseigenschaften, der Legierung vermieden werden, und die Legierung insgesamt verbessert werden.

Obwohl die vorliegende Erfindung anhand der Ausführungsbeispiele detailliert beschrieben worden ist, ist die Erfindung nicht auf diese Ausführungsbeispiele beschränkt, sondern vielmehr sind Abwandlungen in der Weise möglich, dass einzelne Merkmale innerhalb des angegebenen Schutzbereichs der beigefügten Ansprüche verändert werden können. Die Offenbarung schließt sämtliche Kombinationen der vorgestellten Einzelmerkmale mit ein.

## Patentansprüche

1. Nickelbasislegierung für Hochtemperaturanwendungen, insbesondere zur Verwendung in Strömungsmaschinen, mit einer chemischen Zusammensetzung umfasst:
5,9 bis 6,3 Gew.% Al,
6 bis 11 Gew.% Co,
5,5 bis 7,5 Gew.% Cr,
0 bis 0,5 Gew.% Hf,
0 bis 1 Gew.% Mo,
1 bis 2 Gew.% Re,
5 bis 7,8 Gew.% Ta,
5 bis 8,5 Gew.% W,
0,01 bis 1 Gew.% C,
0 bis 0,5 Gew.% Ti,
0 bis 0,01 Gew.% B,
0 bis 0,08 Gew.% Y,
0 bis 0,5 Gew.% Zr,
0 bis 0,8 Gew.% Nb
und Rest Nickel sowie unvermeidbare Verunreinigungen.

2. Nickelbasislegierung für Hochtemperaturanwendungen, insbesondere zur Verwendung in Strömungsmaschinen, mit einer chemischen Zusammensetzung umfasst:
5,9 bis 6,3 Gew.% Al,
8 bis 11 Gew.% Co, insbesondere 8,5 bis 11 Gew.% Co,
5,5 bis 7,5 Gew.% Cr,
0 bis 0,5 Gew.% Hf,
0 bis 1 Gew.% Mo,
1 bis 2 Gew.% Re,
5 bis 7,8 Gew.% Ta,
5 bis 8,5 Gew.% W,
0,01 bis 1 Gew.% C,
0 bis 0,5 Gew.% Ti,
0 bis 0,01 Gew.% B,
0 bis 0,08 Gew.% Y,
0 bis 0,5 Gew.% Zr,
0 bis 0,8 Gew.% Nb
und Rest Nickel sowie unvermeidbare Verunreinigungen.

3. Nickelbasislegierung nach Anspruch 1 mit einer chemischen Zusammensetzung, die umfasst:
5,9 bis 6,3 Gew.% Al,
6 bis 10 Gew.% Co, vorzugsweise 7,5 bis 8,5 Gew.% Co
5,5 bis 7,5 Gew.% Cr,
0 bis 0,5 Gew.% Hf, vorzugsweise 0,1 bis 0,45 Gew.% Hf,
0 bis 1 Gew.% Mo, vorzugsweise 0,4 bis 0,9 Gew.% Mo,
1 bis 2 Gew.% Re, vorzugsweise 1,4 bis 1,7 Gew.% Re,
5 bis 7,5 Gew.% Ta, vorzugsweise 6 bis 7 Gew.% Ta,
5,5 bis 8,5 Gew.% W, vorzugsweise 7 bis 8 Gew.% W, insbesondere 7,1 bis 8 Gew.% W,
0,01 bis 1 Gew.% C, vorzugsweise 0,02 bis 0,07 Gew.% C,
0 bis 0,5 Gew.% Ti, vorzugsweise 0 bis 0,3 Gew.% Ti,
0 bis 0,01 Gew.% B, vorzugsweise 0 bis 0,008 Gew.% B,
0 bis 0,08 Gew.% Y, vorzugsweise 0 bis 0,04 Gew.% Y,
0 bis 0,5 Gew.% Zr, vorzugsweise 0 bis 0,016 Gew.% Zr,
0 bis 0,8 Gew.% Nb, vorzugsweise 0,05 bis 0,1 Gew.% Nb
und Rest Nickel sowie unvermeidbare Verunreinigungen.

4. Nickelbasislegierung nach Anspruch 1 oder 2 mit einer chemischen Zusammensetzung, die umfasst:
5,9 bis 6,3 Gew.% Al,
8 bis 11 Gew.% Co, vorzugsweise 8,5 bis 11 Gew.% Co, insbesondere 8,5 bis 9,5 Gew.% Co,
5,5 bis 7,5 Gew.% Cr,
0 bis 0,5 Gew.% Hf, vorzugsweise 0,1 bis 0,45 Gew.% Hf,,
0 bis 1 Gew.% Mo, vorzugsweise 0,4 bis 0,9 Gew.% Mo,
1 bis 2 Gew.% Re, vorzugsweise 1,4 bis 1,7 Gew.% Re,
5,5 bis 7,8 Gew.% Ta, vorzugsweise 6,5 bis 7,5 Gew.% Ta,
5 bis 8,5 Gew.% W, vorzugsweise 6,5 bis 7,5 Gew.% W,
0,01 bis 1 Gew.% C, vorzugsweise 0,02 bis 0,07 Gew.% C,
0 bis 0,5 Gew.% Ti, vorzugsweise 0 bis 0,3 Gew.% Ti,
0 bis 0,01 Gew.% B, vorzugsweise 0 bis 0,008 Gew.% B,
0 bis 0,08 Gew.% Y, vorzugsweise 0 bis 0,04 Gew.% Y,
0 bis 0,5 Gew.% Zr, vorzugsweise 0 bis 0,016 Gew.% Zr,
0 bis 0,8 Gew.% Nb, vorzugsweise 0,05 bis 0,1 Gew.% Nb
und Rest Nickel sowie unvermeidbare Verunreinigungen.

5. Nickelbasislegierung nach einem der vorhergehenden Ansprüche, die eine einkristalline Nickelbasis-Superlegierung ist, insbesondere mit einer kubisch flächenzentrierten Kristallstruktur.

6. Nickelbasislegierung nach einem der vorhergehenden Ansprüche, die Legierung eine γ - Matrix und γ' - Ausscheidungen umfasst, wobei der Anteil an γ' - Ausscheidungen in der Legierung im Temperaturbereich bis 850°C über 60 Vol.% beträgt.

7. Bauteil einer Strömungsmaschine, insbesondere eines Flugtriebwerks, welches eine Nickelbasislegierung nach einem der vorhergehenden Ansprüche umfasst oder daraus besteht.

8. Bauteil nach Anspruch 7, das eine Leit- oder Laufschaufel ist, insbesondere für eine Turbinenstufe, insbesondere Niederdruckturbinenstufe, eines Flugtriebwerks ist.

9. Bauteil nach Anspruch 7 oder 8, wobei die Nickelbasislegierung einkristallin oder gerichtet erstarrt ausgebildet ist, insbesondere derart, dass die [001]-Kristallrichtung in der hergestellten Leit- oder Laufschaufel um höchstens 15° von der sich in Radialrichtung erstreckenden Schaufelachse abweicht.

10. Bauteil nach Anspruch 8 oder 9, wobei die Turbinenstufe mittels eines Getriebes mit einem Fan der des Flugtriebwerks gekoppelt ist, und die Turbine im Betrieb schneller dreht als der Fan.

11. Verfahren zur Herstellung eines Bauteils nach einem der Ansprüche 7 bis 10, welches den folgenden Schritt umfasst: Gießen einer Schmelze mit einer chemischen Zusammensetzung einer Legierung nach einem der Ansprüche 1 bis 6 in eine Gussform für eine Leit- oder Laufschaufel mit einer jeweiligen Schaufelachse in Radialrichtung, wobei die Gussform einen Impfkristall oder sog. "Starter" umfasst, der eine [001]-Kristallrichtung für ein einkristallines Kristallwachstum festlegt und derart in der Gussform orientiert angeordnet ist, dass die [001]-Kristallrichtung im hergestellten Bauteil um höchstens 15° von der Radialrichtung abweicht.
